# FASCICULE DE BREVET EUROPEEN

(11) **EP 0 976 101 B1**
(45) Date de publication et mention de la délivrance du brevet: **19.09.2001**
(21) Numéro de dépôt: 96934969.5
(22) Date de dépôt: 25.10.1996
(51) Int. Cl.: G06K 19/077, H04M 1/274

(54) **DISPOSITIF HYBRIDE A CONTACTS AFFLEURANTS ET A PRODUCTION DE SIGNAUX ACOUSTIQUES, ET PROCEDE DE FABRICATION**
HYBRIDVORRICHTUNG MIT OBERFLÄCHIGEN KONTAKTEN UND ERZEUGUNG VON AKUSTISCHEN SIGNALEN UND VERFAHREN ZUR IHRER HERSTELLUNG
HYBRID DEVICE WITH FLUSH-MOUNTED CONTACTS FOR GENERATING ACOUSTIC SIGNALS, AND METHOD FOR MAKING SAME

(30) Priorité: 26.10.1995 FR 9512661
(43) Date de publication de la demande: 02.02.2000
(73) Titulaire: GEMPLUS, 13881 Gémenos Cédex (FR)
(72) Inventeur: MARTIN, Philippe, F-21200 Beaune (FR)
(86) Numéro de dépôt international: FR9601668
(87) Numéro de publication internationale: WO9715899

(56) Documents cités:
- EP-A- 0 664 633
- US-A- 5 418 688
- PATENT ABSTRACTS OF JAPAN vol. 11, no. 271 (E-536), 3 Septembre 1987 & JP,A,62 071359 (MATSUSHITA ELECTRIC WORKS LTD), 2 Avril 1987,

## Description

La présente invention se rapporte à un dispositif hybride apte à fonctionner comme une carte à puce à contacts affleurants et/ou à produire des signaux acoustiques transmissibles par voie téléphonique.

Un tel dispositif est très utile notamment pour transférer, de manière sécurisée, des données sous forme cryptée vers un serveur par exemple, à travers une ligne téléphonique. Il permet également un accès aux données stockées en mémoire par l'intermédiaire d'un lecteur extérieur.

Les signaux acoustiques sont produits selon le principe de codage de données par un couple de fréquences de 697 à 1633Hz, et sont plus connues sous l'appellation anglo-saxonne Dual Tone Modulation Frequency (DTMF). En téléphonie, ces signaux DTMF sont utilisés pour la numérotation, la transmission de codes etc.

Actuellement, il est connu de réaliser des dispositifs de production de signaux DTMF. Ainsi, la demande de brevet EP 95 470 001.9 , par exemple, décrit un dispositif de production de signaux DTMF ayant une faible épaisseur qui permet son insertion dans un portefeuille.

Les cartes à puces à contacts affleurants, quant à elles, sont aujourd'hui très connues et sont réalisées en grand nombre. Elles possèdent une très faible épaisseur, normalisée, de l'ordre de 0,8mm.

Le document JP-A-62 071359 (D1) divulgue un dispositif hybride sous la forme d'une carte à puce apte à fonctionner comme une carte à puce à contacts et à produire des signaux acoustiques transmissibles par voie téléphonique. On pourra se reporter également comme état de la technique au document US-A-5 418 688.

En revanche, aucun dispositif hybride, de très faible épaisseur, n'a encore été réalisé en vue d'une double utilisation, soit comme carte à puce à contacts affleurants soit comme carte à production de signaux DTMF par exemple.

En effet, envisager de combiner à la fois des contraintes de format qui imposent une très faible épaisseur et deux fonctions distinctes dans lesquelles entre la réalisation d'un dispositif de production de signaux DTMF présentait un obstacle difficile à franchir sans la démarche inventive du déposant.

La présente invention vise donc à fournir un dispositif hybride, se présentant sous la forme d'une carte de faible épaisseur, apte à fonctionner comme une carte à puce à contacts affleurants et/ou à produire des signaux acoustiques transmissibles par voie téléphonique. Ce dispositif est principalement caractérisé en ce qu'il comprend :
- une première feuille, constituant la surface arrière, supportant un motif d'interconnexions réservé à la fixation de composants électroniques, et comportant une perforation apte à recevoir un micromodule double face de manière à ce que des contacts métalliques appartenant à la première face, dite face externe, du micromodule affleurent la face inférieure de la surface arrière et entrent en contact avec un lecteur extérieur pour établir une communication à la manière d'une carte à puce,
- une deuxième feuille constituant la surface avant, et
- un intercalaire placé entre les deux premières feuilles, comportant des évidements aptes à encadrer les composants électroniques fixés sur la surface arrière, et des métallisations permettant de réaliser une liaison électrique d'une part avec des contacts métalliques appartenant à la deuxième face, dite face interne, du micromodule et d'autre part avec un circuit de production de signaux sonores, couplé à un transducteur sonore et à un résonateur compatible au format carte à puce standard, à savoir environ 0,8 mm, par l'intermédiaire du motif d'interconnexions de la surface arrière, afin d'établir une communication au moyen de signaux acoustiques transmissibles par voie téléphonique.

Un micromodule classique, possédant une seule face, est généralement défini comme étant formé par un ensemble d'éléments notamment composé d'une puce en circuit intégré, de contacts métalliques servant de points de contact du micromodule avec un dispositif extérieur, et d'une protection formée d'une résine recouvrant la puce, des fils de liaison reliant la puce avec les contacts métalliques et, partiellement, les contacts métalliques.

D'autre part, s'il est possible de réduire, de manière connue, l'épaisseur de la plupart des composants électroniques, tels que résistances, condensateurs, puce en circuit intégré, transducteur sonore ou pile par exemple, à une valeur inférieure à 0,8mm; en revanche, il est très difficile de réduire l'épaisseur d'un résonateur.

Un résonateur constitue une base de temps et de fréquence et permet de définir les deux fréquences utilisées pour la production des signaux DTMF. L'épaisseur d'un résonateur classique est de l'ordre de 1,6mm si bien qu'il est impossible de l'utiliser tel quel dans un dispositif d'épaisseur égale à environ 0,8mm. L'enseignement apporté par l'art antérieur contre-indique l'utilisation d'une lame céramique seule comme résonateur car une telle lame est réputée fragile, ne pas préserver ses propriétés dans le temps et ne pas présenter une bonne fiabilité en fonction de la température. Jusqu'à présent, aucune solution satisfaisante n'a été proposée pour réduire l'épaisseur d'un résonateur à une valeur inférieure à 0,8mm. La présente invention a permis de résoudre ce problème. En effet, selon une autre caractéristique de l'invention, le résonateur comporte une lame céramique piezzo-électrique métallisée sur ses deux faces et électriquement reliée à deux condensateurs par l'intermédiaire de points de contact appartenant au motif d'interconnexions.

Cette caractéristique présente un très grand avantage par rapport à l'art antérieur puisque, dans ce cas, l'épaisseur du résonateur est considérablement réduite et devient inférieure à 0,8mm. Le résonateur du dispositif selon l'invention présente en outre de bons résultats qui contredisent les idées reçues de l'art antérieur.

Un autre objet de l'invention se rapporte à un procédé de fabrication d'un tel dispositif hybride. Ce procédé est caractérisé en ce qu'il consiste à :
- réaliser, sur une première feuille constituant la surface arrière du dispositif, un motif d'interconnexion et une perforation,
- fixer des composants électroniques sur le motif d'interconnexions (110), comprenant un circuit de production de signaux sonores (150) couplé à un transducteur sonore et à un résonateur compatible au format carte à puce standard, à savoir environ 0,8 mm,
- appliquer, sur la première feuille, un intercalaire, sur la surface inférieure duquel des métallisations sont préalablement effectuées en vue d'établir une liaison électrique avec le motif d'interconnexions; ledit intercalaire comportant en outre des évidements aptes à encadrer les composants électroniques fixés sur la première feuille,
- placer un micromodule double face dans une cavité formée par la perforation prévue sur la surface arrière du dispositif et la face inférieure de l'intercalaire, de manière à ce que les contacts métalliques de sa face interne soient connectés aux métallisations de l'intercalaire, et à ce que les contacts métalliques de sa face externe affleurent la face inférieure de la surface arrière du dispositif,
- coller une deuxième feuille, constituant la surface avant du dispositif, sur l'intercalaire.

D'autres particularités et avantages de l'invention apparaîtront à la lecture de la description faite à titre d'exemple illustratif et non limitatif en référence aux figures annexées qui représentent :
- les figures 1a et 1b, respectivement une vue de dessus et une vue de dessous d'un dispositif selon l'invention,
- la figure 2, une vue éclatée et simplifiée d'un dispositif selon l'invention,
- la figure 3, un micromodule double face,
- les figures 4a, 4b et 4c, respectivement un résonateur sous forme éclatée, sous forme assemblée et en coupe B-B,
- la figure 5, un organigramme représentant les étapes d'un procédé de fabrication d'un dispositif selon l'invention,
- la figure 6, une vue éclatée d'un dispositif selon l'invention,
- la figure 7, une vue en coupe latérale et éclatée du micromodule de la figure 3 fixé dans un dispositif selon l'invention,
- la figure 8, une vue en coupe latérale d'un transducteur sonore placé dans un dispositif selon l'invention.

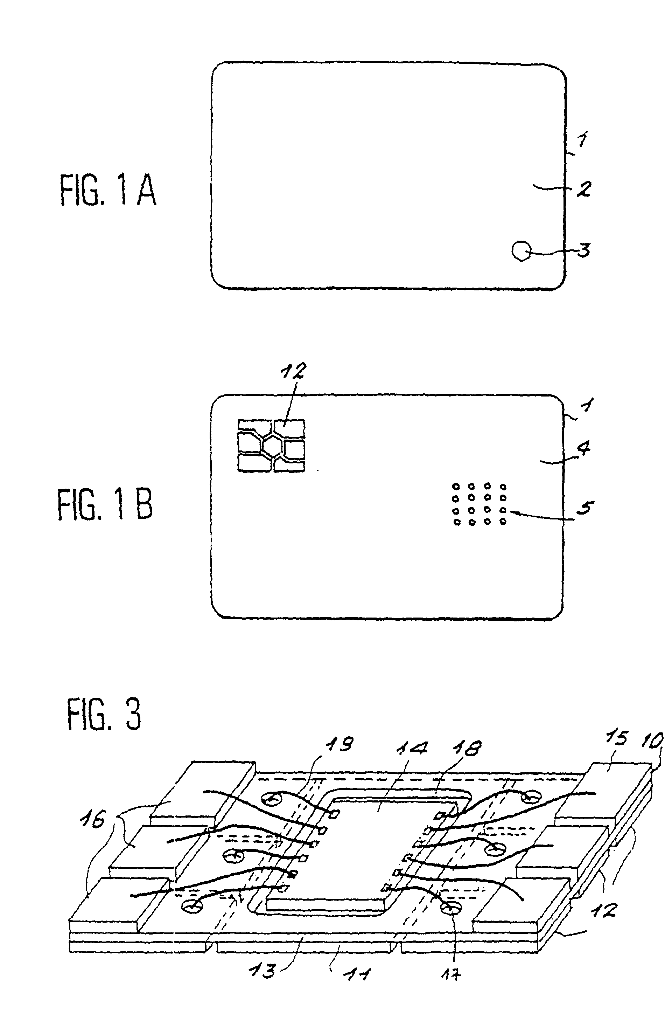

La figure 1a représente une vue de dessus 2, c'est-à-dire une vue de la face supérieure de la surface avant, d'un dispositif 1 selon l'invention. Cette surface avant est plane. Le dispositif selon l'invention est réalisé au format classique des cartes à puce, selon la norme ISO 78.16-12, avec une faible épaisseur de l'ordre de 0,8mm. De manière avantageuse, une touche 3 permet, lorsqu'elle est comprimée, le déclenchement d'un circuit de production de signaux acoustiques. Cependant, selon une variante non représentée il est possible de placer un tel système de déclenchement sur un des côtés longitudinaux du dispositif.

La figure 1b représente une vue de dessous 4 de ce dispositif 1, c'est-à-dire une vue de la face inférieure de la surface arrière. Cette surface arrière comporte des petits trous 5 pour permettre de faciliter l'émission acoustique des signaux DTMF. En outre, des contacts métalliques 12, d'un micromodule intégré, affleurent la surface arrière 4 du dispositif 1.

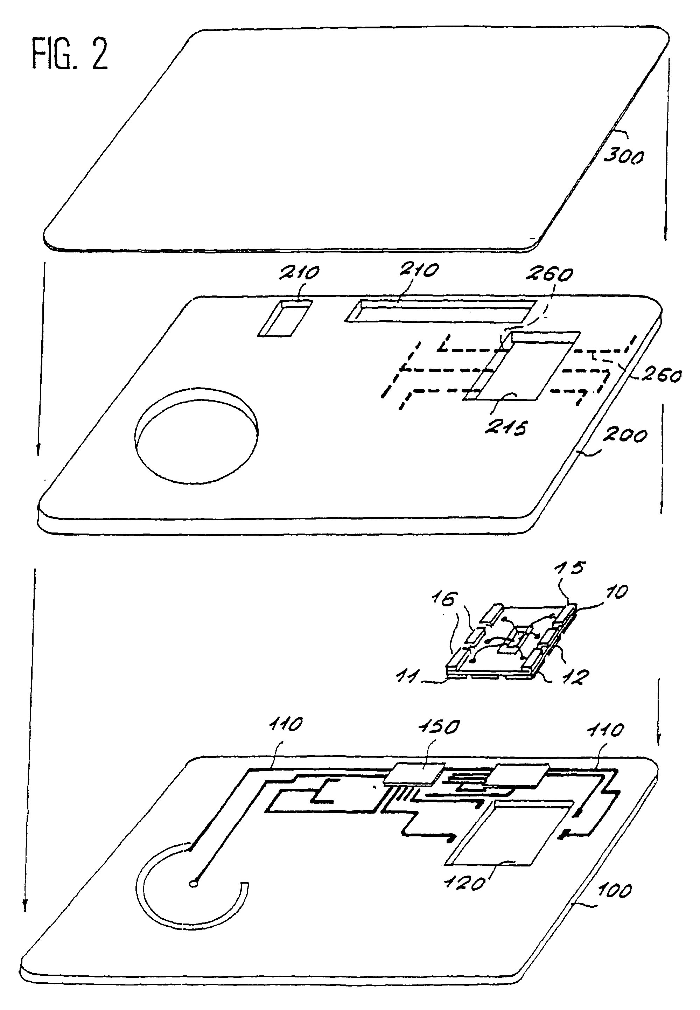

La figure 2 illustre, de manière simplifiée, la structure interne d'un dispositif selon l'invention. Ce dispositif comprend au moins trois parties empilées les unes sur les autres : une première feuille constituant la surface arrière 100, un intercalaire 200, et une deuxième feuille constituant la surface avant 300. La surface arrière 100 supporte, sur sa face supérieure, un motif d'interconnexions 110 réservé à la fixation de composants électroniques, tels qu'un circuit de production de signaux acoustiques couplé à un transducteur sonore, un résonateur et une pile par exemple. Les emplacements correspondant à ces composants électroniques sont délimités par le motif d'interconnexions 110. Seul le circuit de production de signaux acoustiques est représenté, sur la figure 2, par un boîtier référencé 150. De plus, la surface arrière comporte une perforation 120 apte à recevoir un micromodule double face 10 de manière à ce que des contacts métalliques 12 constituant la première face, dite face externe 11, de ce micromodule affleurent la face inférieure de la surface arrière. Ainsi, les contacts affleurants 12 peuvent entrer en contact avec un lecteur extérieur pour établir une communication à la manière d'une carte à puce.

L'intercalaire 200 est fixé sur la surface arrière et comporte des évidements 210 permettant d'encadrer les composants électroniques destinés à être fixés sur le motif d'interconnexions de la surface arrière. Un autre évidement 215 est également prévu sur cet intercalaire, de manière à y loger une partie du micromodule 10 recouverte d'une couche de protection non représentée sur la figure 2. Les dimensions de cet évidement 215 sont inférieures à celles de la perforation 120 située sur la surface arrière. En outre, la face inférieure de l'intercalaire comporte des métallisations 260, représentées en traits pointillés sur la figure 2, pour permettre d'établir une liaison électrique d'une part avec des contacts métalliques 16 constituant la deuxième face, dite face interne 15, du micromodule 10 et d'autre part avec le motif d'interconnexions 110 de la surface arrière 100. Ces métallisations 260 de l'intercalaire permettent ainsi de relier électriquement la face interne 15 du micromodule 10 au circuit 150 de production de signaux DTMF, fixé sur le motif d'interconnexions 110, afin d'établir une communication au moyen de signaux acoustiques transmissibles par voie téléphonique. De manière avantageuse, la liaison électrique entre les métallisations 260 de l'intercalaire et le motif d'interconnexions 110 de la surface arrière est réalisée à l'aide d'un adhésif conducteur anisotrope.

Enfin, la deuxième feuille, constituant la surface avant 300, recouvre l'intercalaire 200 et ferme le dispositif.

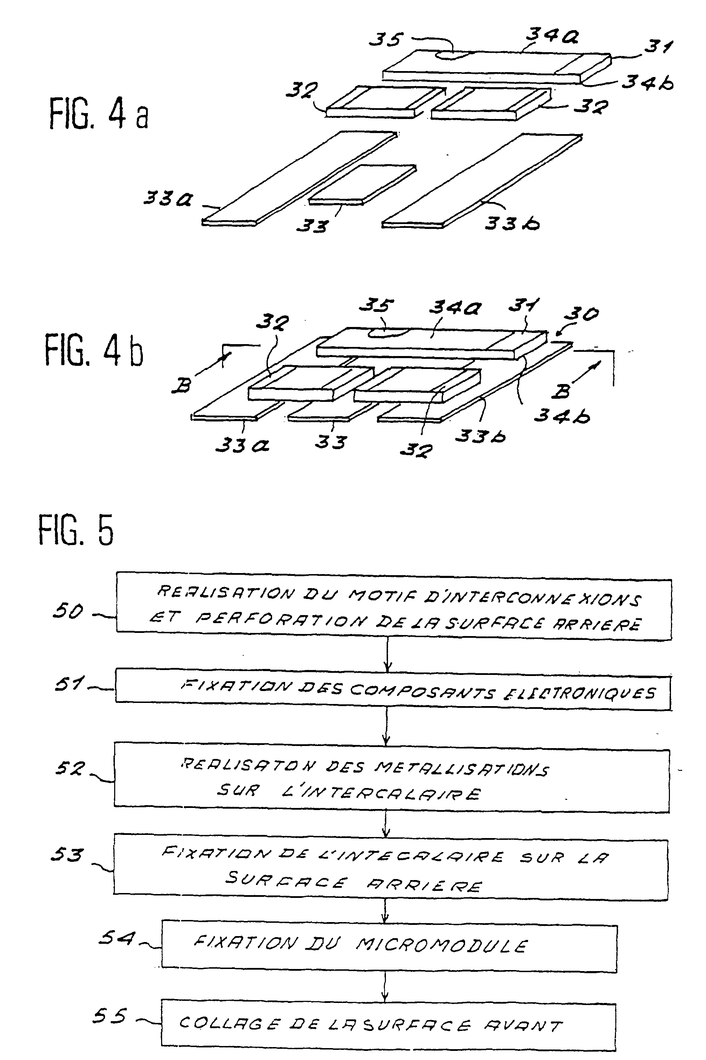

Le micromodule double face 10, intégré dans le dispositif de la figure 2, sera mieux compris au regard de la figure 3. Pour simplifier le schéma de la figure 3, les contacts métalliques du micromodule sont représentés sous forme de carrés. Les contacts métalliques 12 de la face externe 11 constituent un connecteur intermédiaire réalisé, selon un procédé classique, au moyen d'une feuille de cuivre sur laquelle est fixée, par collage par exemple, une feuille diélectrique 13. La feuille diélectrique 13 comprend un ensemble de trous 17, dont la disposition correspond à l'emplacement des contacts 12, et un trou central 18 pour l'emplacement d'une puce en circuit intégré 14. La puce 14 est connectée aux contacts métalliques 12 de la face externe 11 en cuivre, au moyen de fils 19, selon la technique bien connue appelée "bonding", à travers les trous 17 pratiqués dans la feuille diélectrique 13.

Par ailleurs, d'autres contacts métalliques 16 en cuivre, définissant la face interne 15, sont fixés, par collage par exemple, sur la feuille diélectrique 13, de part et d'autre de la puce 14. De la même manière que précédemment décrite, la puce 14 est connectée aux contacts 16, au moyen de fils 19, selon la technique du "bonding". Enfin, une couche de protection, non représentée, formée d'une résine, est placée de manière à recouvrir la puce 14, les fils de liaisons 19 et, partiellement, les contacts métalliques 16 de la face interne 15.

La réalisation d'un dispositif hybride selon l'invention, de manière à ce que l'épaisseur soit égale à celle d'une carte à puce, c'est-à-dire égale à 0,8mm, impose que l'épaisseur des composants électroniques qui y sont insérés soit inférieure à 0,8mm. Aujourd'hui il est relativement facile de réduire l'épaisseur de composants tels que des condensateurs, résistances, piles, puces ou transducteurs sonores par exemple. En effet, on arrive actuellement à obtenir des épaisseurs environ égales à 0,3mm pour des condensateurs ou des piles, à 0,08mm pour des transducteurs sonores en céramique, et à 180 µm (micromètres) pour des puces en circuit intégré.

Cependant, il est très difficile de réduire l'épaisseur d'un résonateur qui, en général, est environ égale à 1,6mm. Jusqu'à présent, tout semblait contre-indiquer l'utilisation d'une seule lame de céramique piezzo-électrique car une telle lame est réputée fragile, ne pas conserver ses propriétés dans le temps et ne pas présenter une bonne fiabilité en fonction de la température. Or, il s'avère que, de manière surprenante, une telle lame offre de bons résultats.

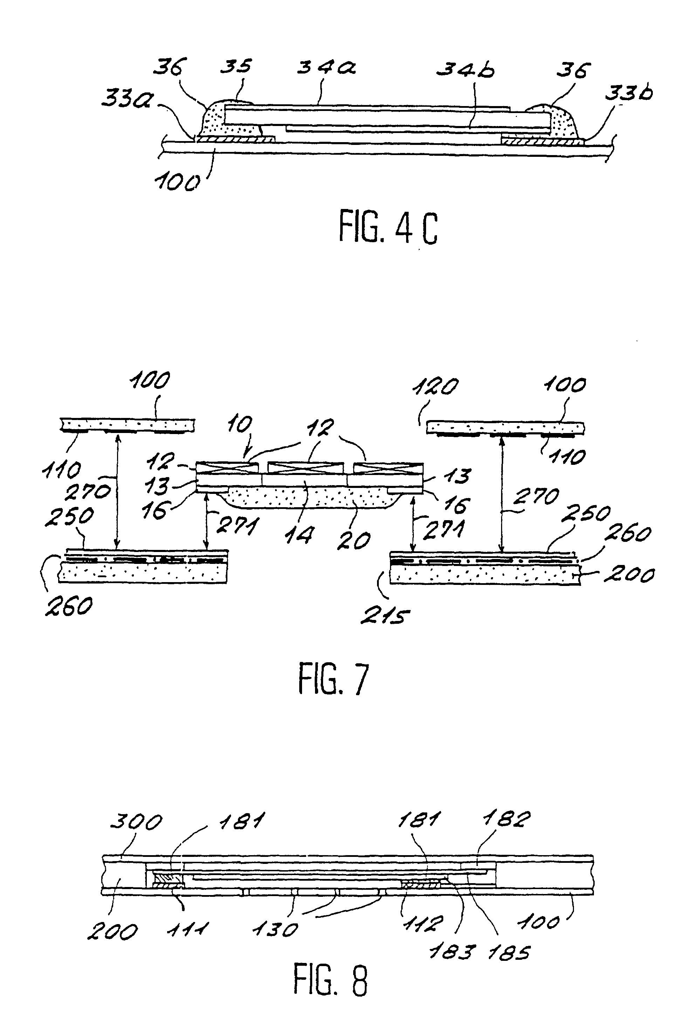

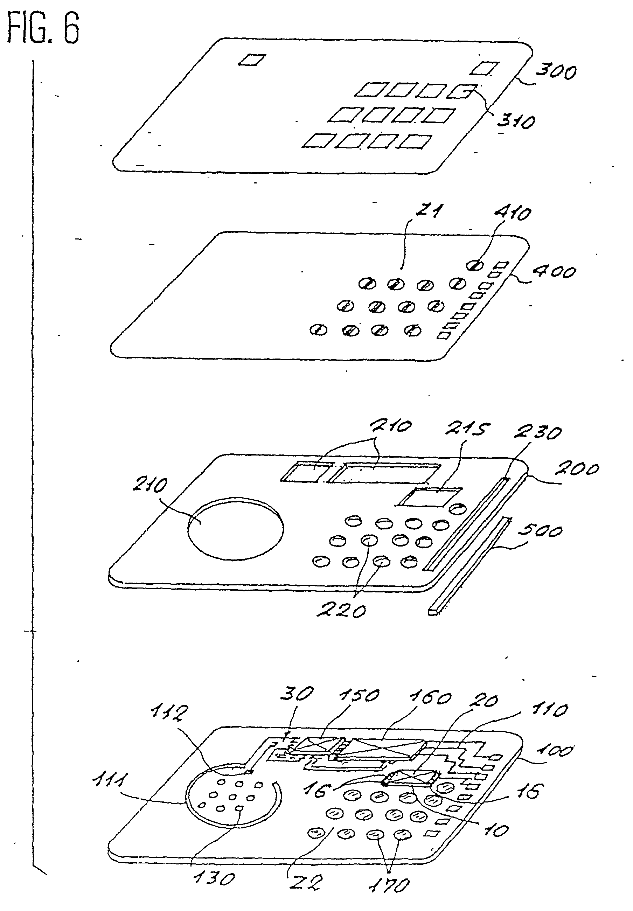

Ainsi, le résonateur 30 d'un dispositif hybride réalisé selon la présente invention, comprend une seule lame de céramique piezzo-électrique 31, comportant des métallisations 34a, 34b sur ses deux faces, tel qu'illustré sur les figures 4a, 4b et 4c en vue éclatée, assemblée et en coupe B-B. Les métallisations 34a, 34b définissent deux électrodes inférieure et supérieure. La lame 31 est fixée, par collage par exemple, sur des points de contacts 33a, 33b du motif d'interconnexions 110 réalisé sur la surface arrière 100 du dispositif. Le collage est avantageusement effectué à l'aide d'un adhésif conducteur 36. De plus, deux condensateurs 32, également métallisés sur leur deux extrémités, sont électriquement reliés l'un à l'autre et à chaque face de la lame céramique 31 par l'intermédiaire des points de contact 33, 33a, 33b, du motif d'interconnexions. Ces condensateurs sont eux-aussi fixés par collage, au moyen d'un adhésif conducteur 36.

Les métallisations supérieure et inférieure 34a et 34b de la lame 31 sont avantageusement décalées l'une par rapport à l'autre, tel que représenté sur la figure 4c. Ceci permet de faire reposer la lame de céramique 31 sur deux points de contacts 33a, 33b et de relier chaque métallisation, séparément, à un point de contact.

De préférence, la métallisation 34a de la face supérieure de la lame 31 est reliée à un premier point de contact 33a, au moyen de l'adhésif conducteur 36 placé à la fois sur un point 35 de la métallisation 34a et sur le point de contact 33a; et la métallisation 34b de la face inférieure de la lame 31 est reliée à un deuxième point de contact 33b, au moyen de ce même adhésif conducteur 36.

Un tel résonateur possède une épaisseur considérablement réduite, puisqu'elle est de l'ordre de 0,3mm, et peut par conséquent être facilement intégré dans un dispositif hybride réalisé selon l'invention, dont l'épaisseur est d'environ 0,8mm.

Un procédé de fabrication d'un dispositif selon l'invention sera mieux compris au regard de l'organigramme de la figure 5. Une première étape 50 de ce procédé consiste à réaliser, par sérigraphie d'encre conductrice ou par évaporation, ou par tout autre procédé de dépôt métallique, le motif d'interconnexions 110 sur la surface arrière 100 du dispositif et à pratiquer une perforation de cette surface arrière de manière à y loger le micromodule double face de la figure 3.

Dans une deuxième étape 51, des composants électroniques, nécessaires au fonctionnement du dispositif, sont fixés sur le motif d'interconnexions, à des emplacements réservés. Leur fixation est de préférence réalisée par collage, au moyen d'un adhésif conducteur par exemple.

A l'étape 52, les métallisations 260 sont effectuées sur la face inférieure de l'intercalaire 200 qui est ensuite fixé (étape 53), par collage sous pression à chaud par exemple, sur la surface arrière 100 du dispositif. Le micromodule double face 10 est alors placé dans une cavité formée par la perforation de la surface arrière et la face inférieure de l'intercalaire, c'est l'étape 54. La mise en place de ce micromodule sera expliquée plus en détails dans ce qui suit. Enfin, la dernière étape 55 consiste à coller, sur l'intercalaire, la feuille constituant la surface avant 300.

La figure 6, qui représente une vue éclatée d'un dispositif selon l'invention, permet de mieux comprendre les détails de sa structure et de son procédé de fabrication. Ce dispositif est composé de plusieurs parties 100, 200, 300, 400 empilées les unes sur les autres et d'un micromodule double face 10 tels que décrits précédemment.

De manière avantageuse, la face supérieure de la première feuille 100 comporte un motif d'interconnexions 110 réservé à la fixation de composants électroniques, une perforation non représentée sur la figure 6 permettant d'y loger le micromodule 10, et plusieurs petits trous 130 destinés à faciliter l'émission acoustique des signaux DTMF. Le motif d'interconnexion 110 est par exemple réalisé par sérigraphie d'encre conductrice, par évaporation, ou par tout autre procédé classique de dépôt métallique. L'ensemble des composants électroniques nécessaires au fonctionnement de ce dispositif est constitué par un circuit 150 de production de signaux acoustiques couplé à un transducteur sonore non représenté sur la figure 6, un résonateur 30, une pile 160, le micromodule 10 et d'autres composants passifs non représentés sur la figure 6. L'emplacement du transducteur sonore sur la surface arrière 100 est délimité par une première électrode 112 et une deuxième électrode circulaire 111, du motif d'interconnexions 110, entourant les petits trous 130. La face interne du micromodule 10 de la figure 3 est représentée, sur la figure 6, avec une couche de protection 20 recouvrant la puce, les fils de liaison et, partiellement, les contacts métalliques 16. L'épaisseur de la surface arrière 100 est de préférence de l'ordre de 0,2mm.

L'intercalaire 200 possède une épaisseur relativement plus élevé que celle de la surface arrière, puisqu'elle est comprise entre 0,4 et 0, 5mm, et comporte des évidements 210 aptes à encadrer les composants électroniques fixés sur le motif d'interconnexions 110 de la surface arrière, et un évidement 215 apte à encadrer la partie, du micromodule 10, recouverte de la couche de protection 20. Le matériau de constitution de cet intercalaire possède de préférence une grande rigidité mécanique. Ainsi, il est par exemple réalisé dans un matériau thermoplastique chargé d'aiguilles et/ou de billes de verre. De plus, cet intercalaire 200 comporte, sur sa face inférieure, des métallisations, non représentées sur la figure 6, permettant d'établir une liaison électrique avec le motif d'interconnexions 110 de la surface arrière, et une connexion avec les contacts métalliques 16 de la face interne 15 du micromodule 10.

La deuxième feuille 300 recouvre l'intercalaire 200, pour former la surface avant du dispositif.

Le résonateur 30 précédemment décrit est avantageusement collé sur le motif d'interconnexion 110 de la surface arrière, au moyen d'un adhésif conducteur. De plus, il est placé de telle sorte que sa longueur soit orientée dans le sens de la largeur du dispositif, afin d'éviter que des contraintes, provoquées par une simple torsion dans le sens de la largeur du dispositif, puissent entraîner la cassure de la lame céramique piezzo-électrique 31.

Cependant, pour qu'il puisse fonctionner, il faut en outre que le résonateur soit placé de manière à ce qu'il y ait de l'air de part et d'autre. Par conséquent, une petite cavité est définie d'un côté par l'épaisseur des métallisations du motif d'interconnexions 110, qui est de l'ordre de quelques dizaines de micromètres (µm), et une plus grande cavité est définie de l'autre côté par l'épaisseur de l'intercalaire diminuée de l'épaisseur du résonateur. De plus, l'évidement correspondant prévu dans l'intercalaire, pour l'encadrer, permet également d'assurer une protection mécanique très efficace de ce résonateur, comme s'il s'agissait d'un boîtier.

La surface arrière 100 et l'intercalaire 200 constituent le corps du dispositif. Ce corps est avantageusement réalisé par une découpe au laser ou alors par hydro-découpe.

Une variante de réalisation, également représentée sur la figure 6, consiste à placer un clavier dans le dispositif hybride selon l'invention. Pour cela, une feuille supplémentaire 400 est placée entre la surface avant 300 et l'intercalaire 200. Cette feuille supplémentaire 400 constitue une première zone de contacts Z1 et supporte des plots de contacts 410 nécessaires à la réalisation du clavier. Ces plots de contacts 410 sont par exemple réalisés par sérigraphie ou tout autre procédé de dépôt, et sont constitués d'un polymère conducteur. De manière avantageuse les plots 410 ainsi déposés possèdent une épaisseur légèrement inférieure à celle de l'intercalaire 200 et comprise entre 0,3 et 0,4mm.

Dans ce cas, la face supérieure de la surface arrière 100, constitue une deuxième zone de contacts Z2 sur laquelle des points de contacts métalliques 170 sont réalisés par sérigraphie ou tout autre procédé de dépôt. De plus, des évidements supplémentaires 220 sont pratiqués sur l'intercalaire 200, à l'emplacement des plots de contact 410.

De cette manière, les plots de contact 410 sont placés en vis-à-vis des points de contact 170 à travers les évidements 220 de l'intercalaire. Les plots de contact 410 de Z1 dessinent chacun deux demi-disques ou des traits en forme de peignes interdigités par exemple, tandis que les points de contact 170 de Z2 sont ronds ou carrés. L'établissement des contacts du clavier s'effectue alors par simple pression des plots de contacts 410, à travers la surface avant, de manière à réunir électriquement les demi-disques-410 de Z1 en formant un court-circuit par simple appui sur les points de contact 170 de Z2. En outre, les deux zones de contacts Z1 et Z2 du clavier sont électriquement réunies au motif d'interconnexions 110 de la surface arrière 100, au moyen d'un polymère conducteur anisotrope 500 qui est déposé dans un évidement 230 pratiqué dans l'intercalaire.

De plus, un graphisme représentant l'emplacement des touches 310 du clavier est avantageusement réalisé, par sérigraphie par exemple, sur la face supérieure de la surface avant 300 du dispositif. Par conséquent, la deuxième feuille 300 constituant la surface avant et/ou la feuille supplémentaire 400 sont constituées d'un matériau plastique apte à être facilement sérigraphié tel qu'un polyester ou un polycarbonate par exemple.

Une autre variante, non représentée, consiste en outre à placer un système de déclenchement du circuit 150 de production de signaux acoustiques dans l'épaisseur de l'intercalaire et sur un des côtés longitudinaux du dispositif. Ceci permet de faciliter l'utilisation du dispositif. De préférence, ce système est placé sur le côté droit pour les droitiers et/ou sur le côté gauche pour les gauchers. Il existe plusieurs sortes de systèmes de déclenchement susceptibles d'être insérés dans le dispositif hybride selon l'invention. En effet, il peut s'agir d'un système électromécanique qui permet d'établir un contact, nécessaire au déclenchement d'une séquence de signaux DTMF, par une action sur un bouton poussoir ou sur un levier par exemple. Il peut également s'agir d'un système électronique, tel qu'un interrupteur sensitif par exemple, dans lequel une plaque métallique, d'épaisseur identique à celle de l'intercalaire, conduit des signaux captés par le corps humain vers des entrées de circuits CMOS qui les amplifient afin d'établir en sortie un état haut, ou bas, servant de déclenchement. Il est aussi possible d'utiliser un matériau en polyvinylidène fluoré (PVDF) qui est susceptible, lorsqu'il est comprimé par une simple pression du doigt, de produire une tension de déclenchement du circuit 150 apte à générer une séquence de signaux DTMF.

Selon une autre variante de réalisation non représentée, il est en outre possible de déposer, sur le motif d'interconnexions, une petite diode électroluminescente (led) qui s'allume lorsqu'elle est activée par le système de déclenchement. Cette diode constitue par conséquent un témoin visuel indiquant le bon déclenchement du circuit de production de signaux acoustiques. Un petit trou, de l'ordre de 1mm de diamètre, est alors pratiqué sur l'intercalaire et sur la surface avant du dispositif, afin de laisser passer la lumière issue de la diode.

La figure 7 permet de mieux comprendre la manière dont le micromodule double face est fixé dans le dispositif hybride selon l'invention. Elle représente en effet une vue en coupe latérale et éclatée du micromodule 10, de la figure 3, placé dans le dispositif de la figure 6. Le micromodule est placé dans une cavité formée par la perforation 120, réalisée sur la surface arrière 100, et par la face inférieure de l'intercalaire 200.

La perforation 120 est prévue sur la surface arrière 100, en vue de placer le micromodule 10 de telle sorte que les contacts métalliques 12 de sa face externe affleurent la face inférieure de la surface arrière 100.

De manière avantageuse, la surface arrière 100 et l'intercalaire 200 sont assemblés par collage sous pression à chaud, c'est à dire à environ 100° C. Pour cela, avant de procéder au pressage à chaud, un film d'adhésif 250 chargé de billes de métal à bas point de fusion, par exemple, est placé entre l'intercalaire 200 et la surface arrière 100. Cet adhésif a non seulement pour but de coller l'intercalaire 200 sur la surface arrière 100 mais aussi de réunir électriquement les métallisations 260, prévues sur la face inférieure de l'intercalaire, avec le motif d'interconnexions 110 de la surface arrière. Les liaisons électriques ainsi créées sont référencées par le nombre 270 sur la figure 7.

De préférence, le nombre de métallisations 260 réalisées sur la face inférieure de l'intercalaire 200 est identique au nombre de contacts métalliques prévus sur la face interne du micromodule. Cependant, dans une variante de réalisation ce nombre peut être inférieur. Un évidement 215 est prévu dans l'intercalaire 200, de manière à y loger la partie du micromodule 10 recouverte d'une couche de protection 20, telle que la résine.

Le micromodule est fixé dans sa cavité, de telle manière que les contacts métalliques 16 de sa face interne soient électriquement reliés aux métallisations 260 de l'intercalaire. Les liaisons électriques ainsi créées sont désignées par la référence 271 sur la figure 7. Pour cela, le micromodule est fixé au moyen de l'adhésif conducteur anisotrope 250 qui est déposé soit dans la perforation 120 réalisée sur la surface arrière 100, c'est-à-dire sur les métallisations 260 de l'intercalaire, soit sur les contacts métalliques 16 de la face interne du micromodule. Les métallisations 260 permettent par conséquent de relier électriquement les contacts métalliques 16, de la face interne du micromodule 10, au circuit de production de signaux acoustiques, fixé sur le motif d'interconnexions 110, afin d'établir une communication au moyen de signaux DTMF.

La figure 8 représente la façon dont un transducteur sonore 180 est mis en place dans le dispositif hybride de la figure 5.
Le transducteur sonore 180 est collé au moyen d'un adhésif conducteur anisotrope 181 ou alors au moyen d'un polymère chargé d'aiguilles métalliques orientées selon l'axe Z, c'est-à-dire selon un axe vertical et perpendiculaire à la surface arrière 100 du dispositif, afin d'assurer une conduction anisotrope entre l'électrode circulaire 111 du motif d'interconnexions 110 et l'électrode inférieure du transducteur 180.
Dans le cas où la liaison électrique est établie au moyen d'un polymère chargé d'aiguilles métalliques, une rondelle 182 est placée sur l'électrode métallique supérieure 185 du transducteur 180 de manière à permettre un contact électrique entre les deux électrodes du transducteur et les deux points de contacts 111, 112, du motif d'interconnexions 110, réservés à l'emplacement du transducteur.
De manière avantageuse une petit cavité 183 est ménagée entre le transducteur et la surface avant 300 du dispositif. Cette cavité présente une faible épaisseur comprise entre 20 et 80µm. Cette faible épaisseur est cependant suffisante pour permettre au transducteur sonore de fonctionner correctement. Une autre cavité 184, de plus grande épaisseur, constituant une chambre acoustique, est créée entre la face supérieure de la surface arrière 100 du dispositif et le transducteur 180. L'épaisseur de cette cavité 184 est comprise entre 0,15 et 0,3 mm. Les petits trous 130 pratiqués sur la surface arrière 100 permettent de faciliter l'émission acoustique des signaux DTMF.
Selon une variante de réalisation, il est également possible de monter le transducteur sur la face inférieure de la surface avant, à l'aide d'un même adhésif anisotrope. Cependant, dans ce cas le motif d'interconnexions 110 est réalisé sur une feuille supplémentaire placée entre la surface avant 300 et l'intercalaire 200, comme par exemple sur la feuille 400 supportant les plots de contacts 410 nécessaires à la réalisation du clavier.

## Revendications

1. Dispositif hybride, se présentant sous la forme d'une carte de faible épaisseur, apte à fonctionner comme une carte à puce à contacts affleurants et/ou à produire des signaux acoustiques transmissibles par voie téléphonique, **caractérisé en ce qu'**il comprend :
- une première feuille, constituant la surface arrière (100), supportant un motif d'interconnexions (110) réservé à la fixation de composants électroniques, et comportant une perforation (120) apte à recevoir un micromodule double face (10), de manière à ce que des contacts métalliques (12) appartenant à la première face, dite face externe (11), du micromodule affleurent la face inférieure de la surface arrière (100) et entrent en contact avec un lecteur extérieur pour établir une communication à la manière d'une carte à puce,
- une deuxième feuille constituant la surface avant (300), et
- un intercalaire (200) placé entre les deux premières feuilles, comportant des évidements (210, 215) aptes à encadrer les composants électroniques fixés sur la surface arrière (100), et des métallisations (260) permettant de réaliser une liaison électrique d'une part avec des contacts métalliques (16) appartenant à la deuxième face, dite face interne (15), du micromodule (10) et d'autre part avec un circuit (150) de production de signaux sonores, couplé à un transducteur sonore et à un résonateur compatible au format carte à puce standard, à savoir environ 0,8 mm, par l'intermédiaire du motif d'interconnexions (110) de la surface arrière, afin d'établir une communication au moyen de signaux acoustiques transmissibles par voie téléphonique.

2. Dispositif selon la revendication 1, **caractérisé en ce qu'**il comprend en outre un résonateur (30) comportant une lame céramique piezzo-électrique (31) métallisée sur ses deux faces, électriquement reliée à deux condensateurs (32) par l'intermédiaire de points de contact (33a, 33b) du motif d'interconnexions (110).

3. Dispositif selon l'une des revendications 1 à 2, **caractérisé en ce que** l'épaisseur du résonateur (30) est égale à 0,3 mm.

4. Dispositif selon l'une des revendications 1 à 3, **caractérisé en ce que** l'intercalaire (200) est constitué d'un matériau thermoplastique chargé d'aiguilles et/ou de billes de verre.

5. Dispositif selon l'une des revendications 1 à 4, **caractérisé en ce que** l'épaisseur de l'intercalaire (200) est comprise entre 0,4 et 0,5 mm.

6. Dispositif selon l'une des revendications 1 à 5, **caractérisé en ce que** la surface arrière (100) possède une épaisseur d'environ 0,2 mm.

7. Dispositif selon l'une des revendications 1 à 6, **caractérisé en ce qu'**il comprend en outre une feuille supplémentaire (400), placée entre la surface avant et l'intercalaire, constituant une première zone de contacts (Z1) supportant des plots de contact (410) nécessaires à la réalisation d'un clavier et en ce que la surface arrière (100) constitue une deuxième zone de contacts (Z2) supportant des points de contact (170) réservés à la réalisation dudit clavier.

8. Dispositif selon la revendication 7, **caractérisé en ce que** la deuxième feuille (300) et/ou la feuille supplémentaire (400) sont constitués d'un matériau plastique apte à être facilement sérigraphié.

9. Dispositif selon la revendication 8, **caractérisé en ce que** la deuxième feuille (300) et/ou la feuille supplémentaire (400) sont en polyester ou en polycarbonate.

10. Dispositif selon l'une des revendications 7 à 9 , **caractérisé en ce que** les plots de contact (410) supportés par la feuille supplémentaire (400) et nécessaires à la réalisation du clavier, sont en matériau polymère conducteur.

11. Dispositif selon l'une des revendications 7 à 10, **caractérisé en ce que** les plots de contact (410) supportés par la feuille supplémentaire (400) et nécessaires à la réalisation du clavier, possèdent une épaisseur comprise entre 0,3 et 0,4 mm.

12. Dispositif selon l'une des revendications 1 à 11, **caractérisé en ce qu'**il comprend en outre, sur un de ses côtés longitudinaux, et dans l'épaisseur de l'intercalaire (200), un système de déclenchement du circuit de production de signaux acoustiques.

13. Dispositif selon la revendication 12, **caractérisé en ce que** le système du déclenchement est un système électromécanique, ou électronique, ou formé d'un matériau susceptible de produire une tension de déclenchement lorsqu'il est comprimé.

14. Procédé de fabrication d'un dispositif hybride selon l'une des revendications 1 à 13, **caractérisé en ce qu'**il consiste à :
- réaliser, sur une première feuille constituant la surface arrière (100) du dispositif, un motif d'interconnexions (110) et une perforation (120),
- fixer des composants électroniques sur le motif d'interconnexions (110), comprenant un circuit de production de signaux sonores (150) couplé à un transducteur sonore et à un résonateur compatible au format carte à puce standard, à savoir environ 0,8 mm,
- appliquer, sur la première feuille, un intercalaire (200) sur la surface inférieure duquel des métallisations (260) sont préalablement effectuées en vue d'établir une liaison électrique avec le motif d'interconnexions (110); ledit intercalaire (200) comportant en outre des évidements (210, 215) aptes à encadrer les composants électroniques fixés sur la première feuille (100),
- placer un micromodule double face (10) dans une cavité formée par la perforation (120) prévue sur la surface arrière (100) du dispositif et par la face inférieure de l'intercalaire (200), de manière à ce que les contacts métalliques (16) de sa face interne (15) soient connectés aux métallisations (260) de l'intercalaire (200), et à ce que les contacts métalliques (12) de sa face externe (11) affleurent la face inférieure de la surface arrière (100) du dispositif,
- coller une deuxième feuille, constituant la surface avant (300) du dispositif sur l'intercalaire (200).

15. Procédé selon la revendication 14, **caractérisé en ce que** le micromodule (10) est fixé au moyen d'un adhésif conducteur anisotrope qui est disposé soit sur les métallisations (260) de l'intercalaire (200) soit sur les contacts métalliques (16) de la face interne (15) du micromodule.

16. Procédé selon l'une des revendications 14 à 15, **caractérisé en ce que** la surface arrière (100) du dispositif et l'intercalaire (200) sont assemblés par collage sous pression à chaud, au moyen d'un film d'adhésif chargé de billes de métal à bas point de fusion, de manière à réunir électriquement les métallisations (260) de l'intercalaire (200) au motif d'interconnexions (110).

17. Procédé selon l'une des revendications 14 à 16, **caractérisé en ce qu'**un résonateur (30) est placé sur le motif d'interconnexions (110) de la surface arrière (100) de telle sorte que sa longueur soit orientée dans le sens de la largeur du dispositif.

18. Procédé selon l'une des revendications 14 à 17, **caractérisé en ce que** la surface arrière (100) et l'intercalaire sont découpés au moyen d'un laser ou par hydro-découpe.

19. Procédé selon l'une des revendications 14 à 18, **caractérisé en ce qu'**il consiste en outre à placer une feuille supplémentaire (400) entre la surface avant (300) et l'intercalaire (200), à réaliser des plots de contacts (410) sur cette feuille supplémentaire, à réaliser des points de contacts (170) sur la surface arrière (100) et à pratiquer des évidements (220) dans l'intercalaire, de manière à ce que les plots de contacts (410) et les points de contacts (170) soient placés en vis-à-vis, à travers les évidements (220) de l'intercalaire, pour former un clavier.

20. Procédé selon l'une des revendications 14 à 19, **caractérisé en ce qu'**il consiste en outre à placer un système de déclenchement du circuit de production de signaux acoustiques dans l'épaisseur de l'intercalaire (200) et sur un des côtés longitudinaux du dispositif.

## Claims

1. A hybrid device in the form of a thin card, able to function as a smart card with flush contacts and/or to produce acoustic signals which can be transmitted by telephone, **characterised in that** it comprises:
- a first sheet, constituting the rear surface (100), supporting a pattern of interconnections (110) reserved for the fixing of electronic components, and having a perforation (120) able to receive a dual-face micromodule (10) so that metallic contacts (12) belonging to the first face, referred to as the external face (11), of the micromodule fit flush with the bottom face of the rear surface (100) and come into contact with an external reader in order to establish communication like a smart card,
- a second sheet constituting the front surface (300), and
- an insert (200) placed between the first two sheets, having recesses (210, 215) able to frame the electronic components fixed to the rear surface (100), and metallisations (260) for effecting an electrical connection on the one hand with metallic contacts (16) belonging to the second face, referred to as the internal face (15), of the micromodule (10) and on the other hand with a sound signal production circuit (150), coupled to a sound transducer and to a resonator compatible with the standard smart card format, namely approximately 0.8 mm, by means of the pattern of interconnections (110) on the rear surface, in order to establish communication by means of acoustic signals which can be transmitted by telephone.

2. A device according to Claim 1, **characterised in that** it also comprises a resonator (30) including a piezoelectric ceramic plate (31) metallised on both faces, electrically connected to two capacitors (32) by means of contact points (33a, 33b) on the pattern of interconnections (110).

3. A device according to one of Claims 1 to 2, **characterised in that** the thickness of the resonator (30) is 0.3 mm.

4. A device according to one of Claims 1 to 3, **characterised in that** the insert (200) consists of a thermoplastic material loaded with glass needles and/or balls.

5. A device according to one of Claims 1 to 4, **characterised in that** the thickness of the insert (200) is between 0.4 and 0.5 mm.

6. A device according to one of Claims 1 to 5, **characterised in that** the rear surface (100) has a thickness of approximately 0.2 mm.

7. A device according to one of Claims 1 to 6, **characterised in that** it also comprises an additional sheet (400), placed between the front surface and the insert, constituting a first contact zone (Z1) supporting contact pads (410) necessary for producing a keypad and in that the rear surface (100) constitutes a second contact zone (Z2) supporting contact points (170) reserved for producing the said keypad.

8. A device according to Claim 7, **characterised in that** the second sheet (300) and/or the additional sheet (400) consist of a plastics material able to be easily screen printed.

9. A device according to Claim 8, **characterised in that** the second sheet (300) and/or the additional sheet (400) are made from polyester or polycarbonate.

10. A device according to one of Claims 7 to 9, **characterised in that** the contact pads (410) supported by the additional sheet (400) and necessary for producing the keypad are made from conductive polymer material.

11. A device according to one of Claims 7 to 10, **characterised in that** the contact pads (410) supported by the additional sheet (400) and necessary for producing the keypad have a thickness of between 0.3 and 0.4 mm.

12. A device according to one of Claims 1 to 11, **characterised in that** it also comprises, on one of its longitudinal sides, and in the thickness of the insert (200), a system for triggering the acoustic signal production circuit.

13. A device according to Claim 12, **characterised in that** the triggering system is an electromechanical or electronic system, or one formed from a material able to produce a triggering voltage when it is compressed.

14. A method for manufacturing a hybrid device according to one of Claims 1 to 13, **characterised in that** it consists in:
- producing, on a first sheet constituting the rear surface (100) of the device, a pattern of interconnections (110) and a perforation (120),
- fixing electronic components to the pattern of interconnections (110), comprising a sound signal production circuit (150) coupled to a sound transducer and to a resonator compatible with the standard smart card format, namely approximately 0.8 mm,
- applying, to the first sheet, an insert (200), on the bottom surface of which metallisations (260) are previously made with a view to establishing an electrical connection with the pattern of interconnections (110); the said insert (200) also having recesses (210, 215) able to frame the electronic components fixed to the first sheet (100),
- placing a dual-face micromodule (10) in a cavity formed by the perforation (120) provided on the rear surface (100) of the device and by the bottom face of the insert (200), so that the metallic contacts (16) on its internal face (15) are connected to the metallisations (260) on the insert (200), and so that the metallic contacts (12) on its external face (11) fit flush with the bottom face of the rear surface (100) of the device,
- gluing a second sheet, constituting the front surface (300) of the device, onto the insert (200).

15. A method according to Claim 14, **characterised in that** the micromodule (10) is fixed by means of an anisotropic conductive adhesive which is disposed either on the metallisations (260) on the insert (200) or on the metallic contacts (16) on the internal face (15) of the micromodule.

16. A method according to one of Claims 14 to 15, **characterised in that** the rear surface (100) of the device and the insert (200) are assembled by gluing, under hot pressure, by means of an adhesive film loaded with low melting point metal balls, so as to electrically connect the metallisations (260) of the insert (200) to the pattern of interconnections (110).

17. A method according to one of Claims 14 to 16, **characterised in that** a resonator (30) is placed on the pattern of interconnections (110) on the rear surface (100) so that its length is oriented in the direction of the width of the device.

18. A method according to one of Claims 14 to 17, **characterised in that** the rear surface (100) and the insert are cut by means of a laser or by water cutting.

19. A method according to one of Claims 14 to 18, **characterised in that** it also consists of placing an additional sheet (400) between the front surface (300) and the insert (200), producing contact pads (410) on this additional sheet, producing contact points (170) on the rear surface (100) and forming recesses (220) in the insert, so that the contact pads (410) and the contact points (170) are placed opposite, through the recesses (220) in the insert, in order to form a keypad.

20. A method according to one of Claims 14 to 19, **characterised in that** it also consists in placing a system for triggering the acoustic signal production circuit in the thickness of the insert (200) and on one of the longitudinal sides of the device.

## Patentansprüche

1. Hybrid-Vorrichtung in Form einer Karte von geringer Dicke, die wie eine Chipkarte mit bündigen Kontakten funktionieren und/oder auf dem Telefonwege übertragbare Schallsignale erzeugen kann, **dadurch gekennzeichnet, dass** sie folgende Elemente umfasst:
- eine erste Folie, die die Rückseite (100) bildet und ein Zusammenschaltungsmotiv (110) für die Befestigung von elektronischen Komponenten trägt und eine Perforation (120) aufweist, in die ein doppelseitiges Mikromodul (10) eingesetzt werden kann, so dass die zur ersten Seite, der sogenannten Außenseite (11) gehörigen Metallkontakte (12) des Mikromoduls bündig mit der Unterseite der Rückseite (100) abschließen und mit einem externen Lesegerät in Kontakt treten, um eine Kommunikation wie mit einer Chipkarte herzustellen,
- eine zweite Folie, die die Vorderseite (300) bildet, und
- eine Zwischenlage (200) zwischen den beiden ersten Folien, die Aussparungen (210, 215) aufweist, um die an der Rückseite (100) befestigten elektronischen Komponenten einzurahmen, sowie Metallisierungen (260), die ermöglichen, über das Zusammenschaltungsmotiv (110) der Rückseite eine elektrische Verbindung herzustellen, einerseits mit den zur zweiten Seite, der sogenannten Innenseite (15) gehörigen Metallkontakten (16) des Mikromoduls (10) und andererseits mit einer Erzeugungsschaltung (150) von Schallsignalen, die an einem Schallwandler und einem mit dem Standard-Chipkartenformat, d.h. etwa 0,8 mm, kompatiblen Resonator gekoppelt ist, um mittels auf dem Telefonwege übertragbaren Schallsignalen eine Kommunikation herzustellen.

2. Vorrichtung nach Anspruch 1, **dadurch gekennzeichnet, dass** sie im übrigen einen Resonator (30) umfasst, der eine beidseitig metallisierte und über Kontaktpunkte (33a, 33b) des Zwischenschaltungsmotivs (110) elektrisch mit zwei Kondensatoren (32) verbundene piezoelektrische Keramikfeder (31) aufweist.

3. Vorrichtung nach einem der Ansprüche 1 bis 2, **dadurch gekennzeichnet, dass** die Dicke des Resonators (30) 0,3 mm beträgt.

4. Vorrichtung nach einem der Ansprüche 1 bis 3, **dadurch gekennzeichnet, dass** die Zwischenlage (200) aus einem mit Nadeln und/oder Glaskugeln geladenen Thermoplast besteht:

5. Vorrichtung nach einem der Ansprüche 1 bis 4, **dadurch gekennzeichnet, dass** die Dicke der Zwischenlage (200) zwischen 0,4 und 0,5 mm beträgt.

6. Vorrichtung nach einem der Ansprüche 1 bis 5, **dadurch gekennzeichnet, dass** die Rückseite (100) eine Dicke von etwa 0,2 mm aufweist.

7. Vorrichtung nach einem der Ansprüche 1 bis 6, **dadurch gekennzeichnet, dass** sie im übrigen eine zusätzliche, zwischen der Vorderseite und der Zwischenlage eingefügte Folie (400) umfasst, die eine erste, für die Herstellung einer Tastatur erforderliche Kontaktstifte (410) tragende Kontaktzone (Z1) bildet, und dass die Rückseite (100) eine zweite, für die Herstellung der besagten Tastatur vorgesehene Kontaktpunkte (170) tragende Kontaktzone (Z2) bildet.

8. Vorrichtung nach Anspruch 7, **dadurch gekennzeichnet, dass** die zweite Folie (300) und/oder die zusätzliche Folie (400) aus einem einfach bedruckbaren Kunststoff bestehen.

9. Vorrichtung nach Anspruch 8, **dadurch gekennzeichnet, dass** die zweite Folie (300) und/oder die zusätzliche Folie (400) aus Polyester oder Polykarbonat bestehen.

10. Vorrichtung nach einem der Ansprüche 7 bis 9, **dadurch gekennzeichnet, dass** die von der zusätzlichen Folie (400) getragenen und für die Herstellung der Tastatur erforderlichen Kontaktstifte (410) aus einem leitenden Polymer-Material bestehen.

11. Vorrichtung nach einem der Ansprüche 7 bis 10, **dadurch gekennzeichnet, dass** die von der zusätzlichen Folie (400) getragenen und für die Herstellung der Tastatur erforderlichen Kontaktstifte (410) eine Dicke zwischen 0,3 und 0,4 mm aufweisen.

12. Vorrichtung nach einem der Ansprüche 1 bis 11, **dadurch gekennzeichnet, dass** sie im übrigen an einer ihrer Längsseiten und in der Dicke der Zwischenlage (200) ein Auslösesystem der Erzeugungsschaltung von Schallsignalen umfasst.

13. Vorrichtung nach Anspruch 12, **dadurch gekennzeichnet, dass** das Auslösesystem ein elektromechanisches oder elektronisches System ist oder aus einem Material besteht, das eine Auslösespannung erzeugt, wenn es zusammengedrückt wird.

14. Herstellungsverfahren einer Hybrid-Vorrichtung nach einem der Ansprüche 1 bis 13, **dadurch gekennzeichnet, dass** es aus folgenden Etappen besteht:
- Herstellung eines Zwischenschaltungsmotivs (110) und einer Perforation (120) auf einer ersten Folie, die die Rückseite (100) der Vorrichtung bildet,
- Befestigung der elektronischen Komponenten auf dem Zwischenschaltungsmotiv (110), bestehend aus einer Erzeugungsschaltung von Schallsignalen (150), die an einem Schallwandler und einem mit dem Standard-Chipkartenformat, d.h. etwa 0,8 mm, kompatiblen Resonator gekoppelt ist,
- Auftragen auf der ersten Folie einer Zwischenlage (200) auf deren Unterseite zuvor Metallisierungen (260) vorgenommen wurden, um eine elektrische Verbindung mit dem Zwischenschaltungsmotiv (110) herzustellen; wobei die besagte Zwischenlage (200) im übrigen Aussparungen (210, 215) aufweist, um die auf der ersten Folie (100) befestigten elektronischen Komponenten einzurahmen,
- Einsetzen eines doppelseitigen Mikromoduls (10) in eine von der an der Rückseite (100) der Vorrichtung vorgesehenen Perforation (120) und der Unterseite der Zwischenlage (200) gebildete Vertiefung, so dass die Metallkontakte (16) seiner Innenseite (15) an die Metallisierungen (260) der Zwischenlage (200) angeschlossen werden, und dass die Metallkontakte (12) seiner Außenseite (11) bündig mit der Unterseite der Rückseite (100) der Vorrichtung abschließen,
- Aufkleben auf die Zwischenlage (200) einer zweiten Folie, die die Vorderseite (300) der Vorrichtung bildet.

15. Verfahren nach Anspruch 14, **dadurch gekennzeichnet, dass** das Mikromodul (10) mittels eines anisotropischen Leitklebers befestigt ist, der entweder auf den Metallisierungen (260) der Zwischenlage (200) oder auf den Metallkontakten (16) der Innenseite (15) des Mikromoduls angeordnet ist.

16. Verfahren nach einem der Ansprüche 14 bis 15, **dadurch gekennzeichnet, dass** die Rückseite (100) der Vorrichtung und die Zwischenlage (200) durch Heißkleben unter Druck mittels einer mit Metallkugeln mit niedrigem Schmelzpunkt geladener Klebefolie zusammengefügt werden, um die Metallisierungen (260) der Zwischenlage (200) mit dem Zwischenschaltungsmotiv (110) elektrisch zu verbinden.

17. Verfahren nach einem der Ansprüche 14 bis 16, **dadurch gekennzeichnet, dass** auf dem Zwischenschaltungsmotiv (110) der Rückseite (100) ein Resonator (30) so angeordnet ist, dass seine Länge in Richtung der Breite der Vorrichtung ausgerichtet ist.

18. Verfahren nach einem der Ansprüche 14 bis 17, **dadurch gekennzeichnet, dass** die Rückseite (100) und die Zwischenlage mit einem Laser oder per Hydro-Stanzen ausgestanzt werden.

19. Verfahren nach einem der Ansprüche 14 bis 18, **dadurch gekennzeichnet, dass** es im übrigen darin besteht, zwischen der Vorderseite (300) und der Zwischenlage (200) eine zusätzliche Folie (400) einzufügen, Kontaktstifte (410) auf dieser zusätzlichen Folie herzustellen, Kontaktpunkte (170) an der Rückseite (100) herzustellen und Aussparungen (220) in der Zwischenlage vorzusehen, so dass sich die Kontaktstifte (410) und die Kontaktpunkte (170) durch die Aussparungen (220) der Zwischenlage hindurch gegenüber liegen, um eine Tastatur zu bilden.

20. Verfahren nach einem der Ansprüche 14 bis 19, **dadurch gekennzeichnet, dass** es im übrigen darin besteht, in der Dicke der Zwischenlage (200) und an einer der Längsseiten der Vorrichtung ein Auslösesystem der Erzeugungsschaltung von Schallsignalen anzuordnen.
